(19) **Europäisches Patentamt**

**European Patent Office**

**Office européen des brevets**

(11) Veröffentlichungsnummer: **0 305 695 B1**

(12) **EUROPÄISCHE PATENTSCHRIFT**

(45) Veröffentlichungstag der Patentschrift: **02.12.92**

(21) Anmeldenummer: **88111243.7**

(22) Anmeldetag: **13.07.88**

(51) Int. Cl.⁵: **B23K 3/00**, H05K 13/04, B25J 15/00

(54) **Lötkopf zum Aufnehmen und Ausrichten von Bauelementen während des Ein- oder Auslötens, insbesondere für oberflächenmontierbare Bauelemente (SMD).**

(30) Priorität: **31.08.87 DE 3729044**

(43) Veröffentlichungstag der Anmeldung:
**08.03.89 Patentblatt 89/10**

(45) Bekanntmachung des Hinweises auf die Patenterteilung:
**02.12.92 Patentblatt 92/49**

(84) Benannte Vertragsstaaten:
**AT BE CH DE FR GB IT LI NL SE**

(56) Entgegenhaltungen:
EP-A- 0 060 896   EP-A- 0 154 552
DE-A- 2 904 377   GB-A- 2 037 391
US-A- 2 481 081   US-A- 4 634 043
US-A- 4 729 713

(73) Patentinhaber: **SIEMENS AKTIENGESELL-SCHAFT**
**Wittelsbacherplatz 2**
**W-8000 München 2(DE)**

(72) Erfinder: **Bunz, Georg**
**Jean-Paul-Richter-Strasse 23**
**W-8000 München 70(DE)**

EP 0 305 695 B1

## Beschreibung

Die Erfindung bezieht sich auf einen Lötkopf zum Aufnehmen und gleichzeitgen Ausrichten von SMD-Bauteilen zum Einoder Auslöten auf einer Leiterplatte.

Bei der Fertigung von elektronischen Flachbaugruppen ist in der letzten Zeit ein Übergang von der herkömmlichen Technik der Einsteckmontage zur Technik der Oberflächenmontage von flach auflötbaren Bauelementen zu verzeichnen. Die hierbei eingesetzten oberflächenmontierbaren Bauelemente (SMD = Surface Mounted Devices) werden durch Bestückautomaten auf den Leiterplatten positioniert, meistens mittels mehrerer Klebstoffpunkte fixiert und anschließénd durch ein übliches Lötverfahren verlötet, womit die elektrische Verbindung hergestellt ist. Die bei derartigen Verfahren auftretenden Fehler, sei es durch Einbau falscher oder defekter Bauelemente oder zum Beispiel durch falsche Positionierung müssen in einem separaten Verfahren durch Auslöten der entsprechenden Bauelemente und entsprechender Korrektur durch fehlerfreies Einlöten von neuen Bauelementen beseitigt werden. Dies geschieht mittels Vorrichtungen, die man im allgemeinen als Ein- und Auslötemaschinen bezeichnet. Derartige auf dem Markt erhältliche Maschinen müssen einer Vielzahl von Qualitätsanforderungen genügen. So ist es erforderlich, daß der Platz eines defekten Bauelementes, welches ausgelötet und durch fehlerfreies Einlöten eines funktionsfähigen Bauelementes ersetzt werden soll, ohne Behinderungen und ohne Parallaxen-Fehler zu betrachten ist. Des weiteren muß die Heizeinrichtung, mit der die Anschlußbeine des Bauelementes zum Aus- oder Einlöten beheizt werden, eine gleichmäßige Temperaturverteilung über die verschiedenen Anschlußbeine aufweisen und darf zugleich den Körper des Bauelementes nicht zu sehr erhitzen. Ebenso werden hohe Anforderungen an die Ausrichtung des Bauelementes bezüglich der Leiterplatte und des Lötplatzes, an die exakte Dosierung von Lotpaste, an die Kühlung des Bauelementes nach dem Einlöten, sowie an die Handhabung eines durch den Bestückautomaten aufgeklebten Bauelementes beim Auslöten in der Ein- oder Auslötmaschine gestellt.

Aus der EP-A-0 154 552 ist ein sog. "pick-up" Kopf bekannt, der ein elektronisches Bauelement, das von ihm gehalten wird, durch mehrere Paare von gegenüberliegenden Klemmbacken zentriert. Ein "pick-up" Kopf kann verschiedene Funktionen beinhalten, bestückt jedoch eine Leiterplatte, ohne die gleichzeitige Verlötung von elektronischen Bauelementen mit der Leiterplatte vorzunehmen.

Weiterhin ist im Stand der Technik aus der US-A-4 634 043 ein Aufnahmekopf für elektronische Komponenten bekannt, der zusätzlich Verbindungsmaterialien zum späteren Verbinden des elektronischen Bauelementes mit einem Substrat aufnehmen kann. Die Stirnseite des Aufnahmekopfes ist speziell an die Form des elektronischen Bauelementes angepaßt.

Die beiden genannten Druckschriften offenbaren jeweils Aufnahmeköpfe für elektronische Bauelemente. Es wird jedoch nicht beschrieben oder nahegelegt, einen Lötkopf zu konstruieren, der elektronische Bauelemente aufnimmt, diese ein- und auslötet, wobei über den Lötkopf Heißgas geführt wird und durch Mittel, die am Lötkopf angebracht sind, gleichzeitig eine Zentrierung der Bauelemente möglich ist. Insgesamt sind aus dem Stand der Technik keine Lötköpfe bekannt, die sämtliche genannten Funktionen auf sich vereinen und eine zuverlässige Ausrichtung eines elektronischen Bauelementes auf eine Einbauposition gewährleisten.

Der Erfindung liegt die Aufgabe zugrunde, einen Lötkopf für Reparaturarbeiten an Leiterplatten mit SMD-Bauteilen zur Verfügung zu stellen, über den die Prozeßwärme auf die Anschlußbeinchen des Bauelementes zuführbar ist und der das Bauelement einfach und zuverlässig ausrichtet bzw. zentriert.

Die Lösung der Aufgabe wird durch den kennzeichnenden Teil des Anspruches 1 wiedergegeben.

Die drei wesentlichen Arbeitsschritte bei der Reparatur einer beschriebenen elektronischen Flachbaugruppe in SMD-Technik beinhalten im wesentlichen die drei Abschnitte - Auslöten, Dosieren der Lotpaste und Einlöten. Die Forderung an ein genaues Ausrichten von Bauelementen kommt vornehmlich beim Wiedereinlöten zum Tragen. Bevor der Lötkopf mittels des Drehtellers und mit dem am Lötkopf gehaltenen Bauelement in seine Arbeitsposition eingeschwenkt wird und die weiteren Arbeitsschritte folgen können, muß die Ausrichtung des SMD-Bauelementes bezogen auf den Lötkopf bereits geschehen sein. Dies wird durch den Einsatz einer Zentrierbacke, die relativ zu einem Anschlag verfahrbar ist oder durch zwei Zentrierbacken, die gegeneinander verfahrbar sind, erreicht. Der Ablauf ist so, daß mittels manueller Bestückung ein SMD-Bauteil an den entsprechenden Lötkopf gehalten wird, die Zentriereinrichtung zugreift, das SMD-Bauteil zentriert und festhält, anschließend eine Vakuumansaugeinrichtung die Halterung des SMD-Bauteils übernimmt und die Zentriereinrichtung das Bauteil wieder freigibt. Dabei ist bereits eine vorteilhafte Ausgestaltung der Erfindung, nämlich die Vakuumansaugeinrichtung genannt.

Weitere vorteilhafte Ausgestaltungen sind den Ansprüchen 2 bis 3 zu entnehmen.

Die Ausführung des Lötkopfes mit zwei Zentrierbackenpaaren, die zueinander senkrecht stehen und durch seitliches Überlappen zu den Seiten hin annähernd gasdicht abschließen, wird in der Regel nur für Bauteile verwendet, die zu allen vier Seiten hin mit Anschlußbeinen versehen sind.

Eine wichtige Funktion der Zentrierbacken besteht darin, daß bei einer Beheizung der Lötung mittels Heißgas die Flächen der Zentrierbacken zugleich zur Führung des Heißgasstromes herangezogen werden.

Im folgenden wird ein Ausführungsbeispiel anhand der schematischen Figuren beschrieben.

Fig. 1    zeigt eine Ein- oder Auslötmaschine für SMD-Bauelemente 13 auf einer Leiterplatte 3,

Fig. 2    zeigt eine Zentrierbacke 16 mit einem Anschlag 17, separiert vom Lötkopf 1 gezeichnet,

Fig. 3    zeigt einen Lötkopf mit Sichtschacht und Fenster 22, sowie zwei Zentrierbackenpaaren 23.

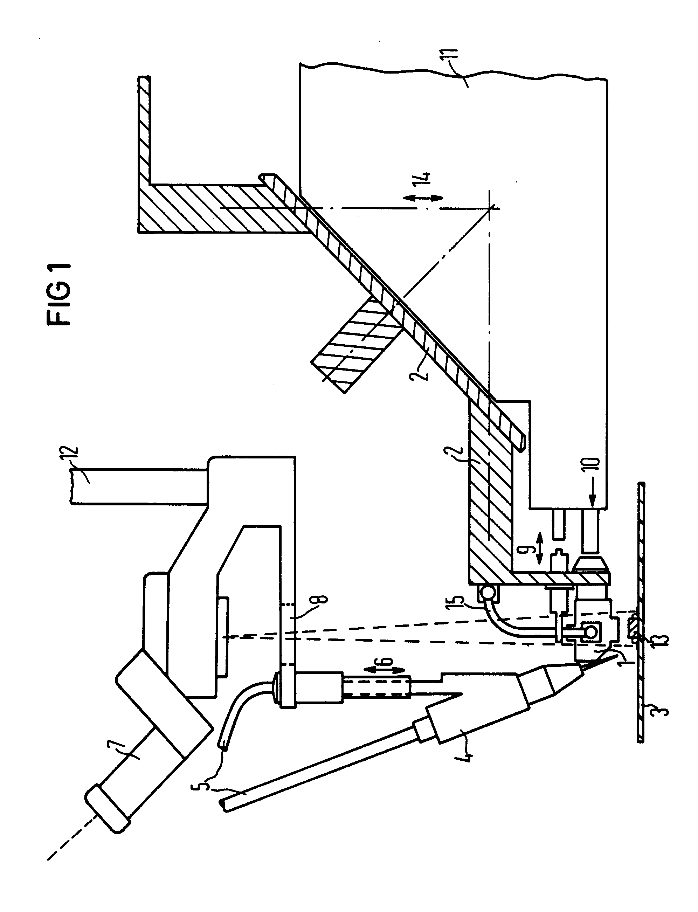

In Fig. 1 ist schematisch eine Ein- oder Auslötmaschine dargestellt. Sie enthält folgende wesentlichen Teile:
-   den Lötkopf 1
-   den Drehteller 2
-   die Leiterplatte 3
-   ein SMD-Bauelement 13
-   eine Dosiervorrichtung 4 für Lotpaste mit
-   Druckluftanschluß 5 und
-   Hubzylinder 6, sowie
-   Sichtfenster 8
-   eine Optik 7, hier ein Mikroskop
-   ein Stativ 12 für die Optik 7 und Dosiervorrichtung 4
-   ein Stativ 11 für den Drehteller 2 mit
-   einer Hubeinrichtung 14
-   eine Vakuumleitung 15
-   einen Hubzylinder 9
-   eine Heißgaszuführung 10.

Der am Drehteller 2 über einen Auslegearm befestigte Lötkopf 1 ist in seiner Arbeitsstellung derart positioniert und arretiert, daß mittels der Optik 7 das SMD-Bauelement 13 von oben durch das Sichtfenster 8 und durch den Lötkopf hindurch betrachtet werden kann. Durch Drehen des Drehtellers 2 können verschiedene an ihm über Auslegearme befestigte Lötköpfe bereit gestellt und in Arbeitsposition geschwenkt werden. Dargestellt ist lediglich ein zweiter Auslegearm, der jedoch nicht mit einem Lötkopf 1 versehen ist. Zum Ein- oder Auslöten wird über die Heißgaszuführung 10 dem Lötkopf 1 ein Heißgas zugeführt, daß im Lötkopf 1 auf die Anschlußbeine des SMD-Bauteils 13 geleitet wird und diese auf die nötige Löttemperatur von beispielsweise 210° oder 225° C erhitzt. Über den Hubzylinder 9 werden die im Lötkopf 1 enthaltenen Zentrierbacken betätigt, die das SMD-Bauelement 13 zeitweise zentrieren und festhalten. Eine weitere Halterung des SMD-Bauelementes 13 am Lötkopf 1 ist durch eine Vakuumeinrichtung gegeben, die über eine Vakuumleitung 15 versorgt wird. Die exakte Positionierung des Lötkopfes 1 relativ zu dem SMD-Bauelement 13 geschieht zum einen durch die in x/y-Richtung mögliche Verschiebung der Leiterplatte 3, sowie über die Hubeinrichtung 14, die den Lötkopf bezüglich der Höhe einstellt. Die Dosiervorrichtung 4 wird über die Druckluftanschlüsse 5 versorgt und durch den Hubzylinder 6 zum Aufbringen einer genau dosierten Menge von Lotpaste auf die Leiterplatte senkrecht nach oben oder nach unten bewegt. Auch hier ermöglicht die Optik 7 zusammen mit der senkrechten Betrachtungsweise durch den Lötkopf 1 hindurch eine parallaxenfreie Betrachung des Ein- oder Auslötplatzes. Hierzu sind durch die Optik 7 in der Regel nur die Anschlußbeine des SMD-Bauteiles 13 sichtbar. Der zentral sitzende Körper des SMD-Bauteiles 13 ist durch die Vakuumeinrichtung verdeckt, die das Bauteil zeitweise hält.

Eine derartige Ein- oder Auslötmaschine für SMD-Bauteile 13 ist durch den Einsatz von Computerprogrammen automatisierbar. Hierzu sind drei wesentliche Arbeitsschritte zu benennen - das Auslöten, das Dosieren der Lotpaste, das Einlöten eines neuen SMD-Bauteiles.

Der Ablauf ist wie folgt:

Auslöten

Über eine Grobjustierung wird der Lötkopf 1 ca. 20 mm über das SMD-Bauteil 13 gefahren und anschließend über eine Feinjustierung auf ca. 1 bis 2 mm angenähert und in x/y-Richtung ausgerichtet, so daß er direkt über dem Bauteil steht. Mittels des über den Lötkopf geführten Heißgases 10 werden die Anschlußbeine des SMD -Bauelementes 13 von Raumtemperatur mit einer Geschwindigkeit von etwa 1,5° C pro Sekunde bis auf ca. 200° C aufgeheizt. Anschließend wird der Lötkopf 1 auf das Bauelement 13 abgesetzt und das Vakuum eingeschaltet, wodurch das Bauelement am Lötkopf angesaugt und gehalten wird. Während des nun einsetzenden eigentlichen Auslötprozesses wird innerhalb von 5 bis 15 Sekunden die Temperatur von 200 bis 210° C oder beispielsweise 225° C erhöht und das Lot zum Fließen gebracht. Der Lötkopf hebt anschließend mit dem Bauelement ab. Die angegebenen Zahlenwerte beziehen sich auf den Einsatz einer üblichen Lotpaste.

Dosieren

Bei in Arbeitsposition eingeschwenktem oder auch ausgeschwenktem Lötkopf 1 wird über die Dosiervorrichtung 4 eine exakt dosierte Menge Lötpaste auf die Anschlußflecken auf der Leiterplatte 3 aufgebracht. Dazu wird die Dosiervorrichtung 4 bis auf einen Abstand von ca. 1 bis 2 mm zur Leiterplatte 3 abgesenkt. Der Hubzylinder 6 sorgt für das Absenken einer Dosiernadel der Dosiervorrichtung 4. Die Menge der notwendigen Lotpaste kann über den Druck in der Druckluftzuführung 5, über die Zeit oder über den Durchmesser der Dosiernadel gesteuert werden.

Einlöten

Das Einlöten geschieht in entsprechender Weise wie das Auslöten. Das SMD-Bauelement 13 wird von dem Lötkopf 1 aufgenommen, mittels Zentrierbacken zentriert und über ein Vakuum festgehalten. Die Zentrierbacken sind in diesem Zustand wieder gelöst. Nach einer Grobpositionierung erfolgt das Absenken auf die Leiterplatte und die Feinjustierung, wobei mit der Opitk 7 kontrolliert wird. Innerhalb der ersten Phase des Aufheizens wird wiederum mit einer Geschwindigkeit von ca. 1,5° C pro Sekunde bis auf ca. 200° C vorgeheizt und beispielsweise beim Einsatz einer handelsüblichen Lotpaste innerhalb von weiteren 5 bis 15 Sekunden auf ca. 225° C erhitzt. Die Halterung durch Ansaugen mittels Vakuum wird anschließend abgeschaltet, wobei gleichzeitig, um eine Nacherhitzung des Körpers der SMD-Bauteile 13 zu vermeiden, etwa 10 Sekunden lang kalte Luft direkt über die Vakuumleitung auf das SMD-Bauelement geblasen wird. Der Lötkopf 1 hebt nun ab und der Einlötvorgang ist beendet.

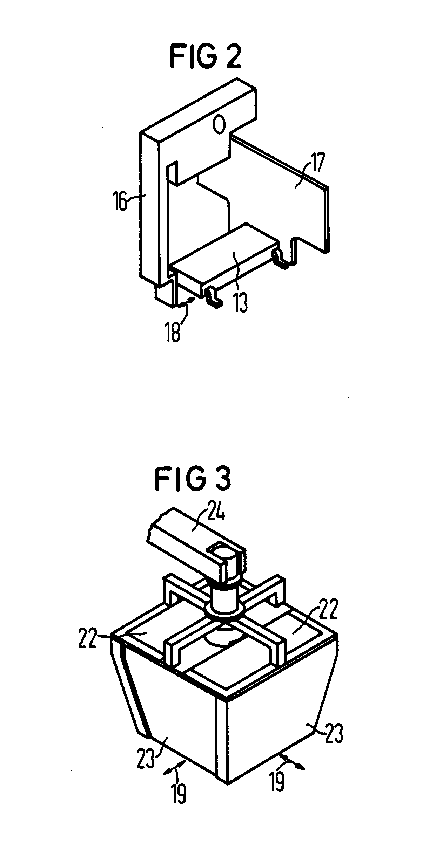

In der Fig. 2 ist separat vom Lötkopf eine Zentrierbacke 16 dargestellt, die sich durch die Hubbewegung 18 gegenüber dem festen Anschlag 17 bewegt. Somit wird ein SMD-Bauteil 13 festgehalten und zentriert.

Sind der Lötkopf 1 und die Leiterplatte 3 im gleichen karthesischen Koordinatensystem achsparallel ausgerichtet, so wird das SMD-Bauelement 13, dessen Anschlußbeine in Richtung der Leiterplatte zeigen, vom Lötkopf 1 mittels der Zentrierbacke 16 derart ausgerichtet, daß das SMD-Bauelement 13 auch jeweils achsparallel zur Leiterplatte plaziert ist. Durch die x/y-Verschiebemöglichkeit der Leiterplatte 3 und durch die Hubeinrichtung 14 lassen sich Bauelement 13 und Leiterplatte 3 im karthesischen Koordinatensystem so gegeneinander verfahren, daß die richtige Lötposition mit dem bereits zentrierten Bauteil erreicht werden kann.

In der Fig. 3 ist eine spezielle Ausführung des Lötkopfes dargestellt, die eine Aufhängung 24 aufweist, ein Sichtfenster 22 und zwei Zentrierbackenpaare 23. Die Hubbewegung 19 deutet die Bewegungsrichtung der Zentrierbacken 23 an. Ein derartiger Lötkopf wird für SMD-Bauelemente eingesetzt, die an allen vier Seiten mit Anschlußbeinen versehen sind.

## Patentansprüche

1. Lötkopf (1) zum Ein- und Auslöten von elektronischen Bauelementen (13), insbesondere für oberflächenmontierbare Bauelemente (SMD), mit
   - einer Beheizung von Anschlußbeinen der elektronischen Bauelemente (13) mittels Heißgas, das auf die Anschlußbeine gerichtet und durch den Lötkopf (1) hindurchführbar ist,
   - mindestens einer Zentrierbacke (16; 23), die relativ zu einem Anschlag (17) oder zu einer weiteren Zentrierbacke (16; 23) verfahrbar ist und ein aufgenommenes elektronisches Bauelement (13) jeweils ausrichtet bzw. zentriert.

2. Lötkopf (1) nach Anspruch 1, **dadurch gekennzeichnet,** daß der Lötkopf (1) zwei Zentrierbackenpaare (16;23) aufweist, die zueinander senkrecht stehen.

3. Lötkopf (1) nach einem der vorhergehenden Ansprüche, **dadurch gekennzeichnet,** daß die Zentrierbacken (16;23) durch seitliches Überlappen annähernd gasdicht abschließen.

4. Lötkopf (1) nach einem der vorhergehenden Ansprüche, dadurch **gekennzeichnet,** daß der Lötkopf (1) zum Festhalten von Bauelementen (13) eine Vakuum- Ansaugeinrichtung enthält.

## Claims

1. Soldering head (1) for soldering and desoldering electronic devices (13), especially for surface-mounted devices (SMD), having
   - a heater for the connecting legs of the electronic devices (13) by means of hot gas which is directed onto the connecting legs and can be passed through the soldering head (1),
   - at least one centring jaw (16; 23) which can be moved relative to a stop (17) or relative to a further centring jaw (16; 23), and in each case aligns and centres an electronic device (13) which is held.

2. Soldering head (1) according to Claim 1, characterised in that the soldering head (1) has two centring jaw pairs (16; 23) which are at right angles to one another.

3.   Soldering head (1) according to one of the preceding claims, characterised in that the centring jaws (16; 23) close in an approximately gas-tight manner by overlapping at the sides.

4.   Soldering head (1) according to one of the preceding claims, characterised in that the soldering head (1) contains a vacuum suction device for holding the devices (13) firmly.

**Revendications**

1.   Tête de brasage (1) pour souder et dessouder des composants électroniques (13), notamment pour des composants (SMD) installés en surface, comportant
   - un dispositif de chauffage de pattes de raccordement des composants électroniques (13) au moyen d'un gaz chaud, qui peut être dirigé sur les pattes de raccordement et peut traverser la tête de brasage (1),
   - au moins une mâchoire de centrage (16;23), qui peut être déplacée par rapport à une butée (17) ou à une autre mâchoire de centrage (16;23) et aligne ou centre respectivement un composant électronique (13) reçu.

2.   Tête de brasage (1) suivant la revendication 1, caractérisée par le fait que la tête de brasage (1) possède deux couples de mâchoires de centrage (16;23), qui sont perpendiculaires entre eux.

3.   Tête de brasage (1) suivant l'une des revendications précédentes, caractérisée par le fait que les mâchoires de centrage (16;23) réalisent une fermeture presque étanche aux gaz, grâce à un chevauchement latéral.

4.   Tête de brasage (1) suivant l'une des revendications précédentes, caractérisée par le fait que la tête de brasage (1) comporte un dispositif de mise en dépression par aspiration, pour maintenir des composants (13).

FIG 1

# FIG 2

16 17 13 18

# FIG 3

24 22 22 23 23 19 19